# EUROPEAN PATENT SPECIFICATION

(11) **EP 2 878 993 B1**
(45) Date of publication and mention of the grant of the patent: **10.07.2019**
(21) Application number: 14195106.1
(22) Date of filing: 27.11.2014
(51) Int. Cl.: G02F 1/1335

(54) **Liquid crystal display device for dashboard of vehicle**
Flüssigkristallanzeigevorrichtung für Armaturenbrett eines Fahrzeugs
Dispositif d'affichage à cristaux liquides pour tableau de bord de véhicule

(30) Priority: 29.11.2013 KR 20130147734
(43) Date of publication of application: 03.06.2015
(73) Proprietor: LG Display Co., Ltd., Seoul 150-721 (KR)
(72) Inventor: Ji, SeungHoon, Changwon-si, Gyeongsangnam-do (KR); Lee, MiKyung, Daegu (KR)
(74) Representative: Viering, Jentschura & Partner mbB Patent- und Rechtsanwälte

(56) References cited:
- JP-A- 2009 151 245
- US-A1- 2012 057 098
- WU H T ET AL: "Nano-particles formation for pigment red 177 via a continuous supercritical anti-solvent process", JOURNAL OF SUPERCRITICAL FLUIDS, PRA PRESS, US, vol. 33, no. 2, 1 February 2005 (2005-02-01), pages 173-182, XP027818792, ISSN: 0896-8446 [retrieved on 2005-02-01]
- YANG CHIH-CHIEH ET AL: "Highly stable three-band white light from an InGaN-based blue light-emitting diode chip precoated with (oxy)nitride green/red phosphors", APPLIED PHYSICS LETTERS, AMERICAN INSTITUTE OF PHYSICS, US, vol. 90, no. 12, 20 March 2007 (2007-03-20), pages 123503-123503, XP012093758, ISSN: 0003-6951, DOI: 10.1063/1.2714326

## Description

### BACKGROUND OF THE INVENTION

### 1. Field of the Invention

The present disclosure relates to a liquid crystal display device, and particularly, to a liquid crystal display device for a dashboard of a vehicle capable of representing a deep red color in a digital dashboard.

### 2. Background of the Invention

In general, a dashboard of a vehicle displays basic information such as a speed of a vehicle, an RPM, an amount of fuel, a temperature of a coolant, a running distance, and the like, and, in particular, recently, as the digital technology has been advanced, various types of information such as a state of a vehicle, display of a rear side, navigation, and the like, as well as the basic information of a vehicle, are displayed. In addition, in order to display various types of information, a flat panel display device such as a liquid crystal display (LCD) is employed in a dashboard.

However, the use of an LCD as a display device for a dashboard has the following problems.

In general, various types of information such as safety-related information, vehicle information, warning information, and the like, are displayed on a dashboard. In this case, the safety-related information is displayed in a green color, information regarding a vehicle is displayed in a blue color, and warning - related is displayed in a red color.

Among the various types of information displayed on a dashboard, the information related to warning is displayed in a red color to increase visibility of a driver to draw his or her attention to thus protect the driver from a risk.

However, in case of displaying a red warning light by using an LCD, purity of a red color is degraded, relative to a conventional dashboard using an LED, and degrading visibility for a driver may result in failure to draw driver's attention, relative to the related art.

US 2012/057098 A1 describes a liquid crystal display element including a color filter having at least one red filter segment made of a red photosensitive resin composition including a pigment combination which seems to include an azo-based red pigment and an athraquinone-based red pigment.

JP2009151245 relates to a display device for automotive applications, wherein the colour filter used is an anthraquinone type filter and the backlight comprises a white LED.

### SUMMARY OF THE INVENTION

The invention provides a light emitting device according to claim 1. Further embodiments of the invention are described in the dependent claims.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a view illustrating partial color coordinates of a display devices for an analog dashboard and a digital dashboard.
FIG. 2 is a cross-sectional view illustrating a liquid crystal display (LCD) device according to an exemplary embodiment of the present disclosure.
FIG. 3A is a plan view illustrating a liquid crystal display panel according to an exemplary embodiment of the present disclosure.
FIG. 3B is a cross-sectional view of the liquid crystal display panel according to an exemplary embodiment of the present disclosure.
FIG. 4 is a graph illustrating spectrum characteristics of an R-color filter using a color resin having anthraquinone pigment dispersed therein and an R-color filter using a color resin having DDP pigment dispersed therein;
FIG. 5 is a cross-sectional view illustrating a structure of a W-LED according to an exemplary embodiment of the present disclosure.
FIG. 6 is a graph illustrating luminance of a W-LED according to an exemplary embodiment of the present disclosure and a general W-LED.

### DETAILED DESCRIPTION OF THE INVENTION

Description will now be given in detail of the exemplary embodiments, with reference to the accompanying drawings. For the sake of brief description with reference to the drawings, the same or equivalent components will be provided with the same reference numbers, and description thereof will not be repeated.

In an exemplary embodiment of the present disclosure, a red color of a liquid crystal display (LCD) for a dashboard is displayed as a red color having the same level as that of a light emitting diode (LED), thus enhancing visibility of a driver and preventing an accident in advance.

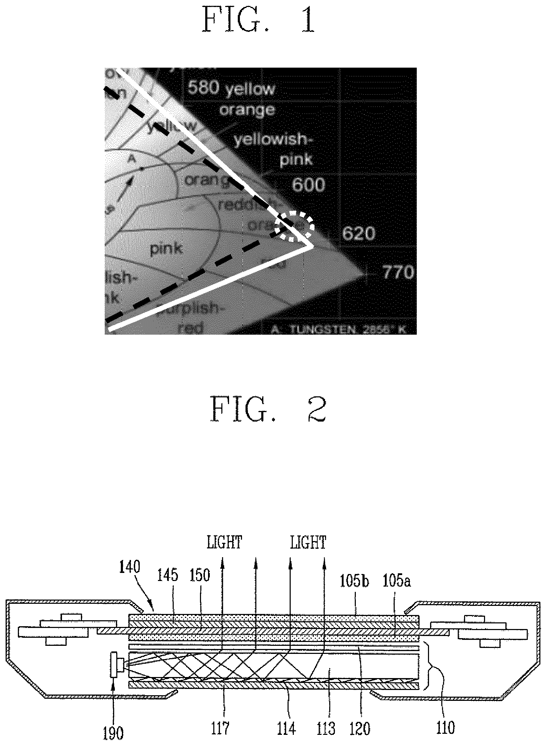

FIG. 1 is a view illustrating colors of a general LCD on color coordinates, in which a white line is a color when an LED is used, and a black line is a color of an LCD device. In this case, in the drawing, only color coordinates in the red color are illustrated.

As illustrated in FIG. 1, in case of an LED, z-coordinates, which represent the wavelength of a red color component, extend to z=620, and thus, in representing a red color, z- coordinates is z=620. In comparison, in case of an LCD device, z-coordinates extend to z=610, and thus, in representing a red color, z-coordinates is z=610. Thus, in implementing a red color, it is difficult for an LCD device to implement a deep red color. Substantially, in case of an LCD device, when full red is implemented, an actually displayed color is not deep red but orange-red.

When an LCD device is applied to a dashboard of a vehicle, when a warning light is implemented in a red color, deep red is not displayed but orange-red is displayed. Of course, a driver may recognize warning according to the display of the orange-red while driving, but since the color is not deep red, recognition of the warning may be delayed. The delay in recognition may result from a difference in color as well as from a difference in custom. Namely, since a dashboard of a vehicle, as an analog dashboard, has used with a red light or a red LED, and warning has been displayed with a deep red color. Thus, when the deep red color is displayed, drivers may instantly recognize warning, but in case of a color such as orange-red, rather than deep red, drivers may recognize warning with the lapse of a certain time, rather than instantly.

In case of a vehicle moving at a high speed, a recognition in difference of even a short time may cause a serious problem. Thus, in the present disclosure, in case of applying an LCD to a dashboard, the same level of red color as that of the related art LED applied to a dashboard is implemented to allow a driver to recognize warning within a short time.

FIG. 2 is a view illustrating a structure of an LCD (liquid crystal display) for a dashboard according to an exemplary embodiment of the present disclosure.

As illustrated in FIG. 2, an LCD device 100 includes a liquid crystal display panel 140 and a backlight 110. In this case, the backlight 110 is positioned below the liquid crystal display panel 140 to supply light to the liquid crystal display panel 140.

The backlight 110 includes a light source 190 for emitting light to supply light to the liquid crystal display panel 140, a light guide plate 113 disposed below the liquid crystal display panel 140 to be facing with the light source 190 to supply light from the light source 190 through the lateral surface thereof to the liquid crystal display panel 140, a reflective plate 117 disposed below the light guide plate 113 to reflect light incident through the lower side of the light guide plate 113 toward the liquid crystal display panel 140, and an optical sheet 120 disposed between the light guide plate 113 and the liquid crystal display panel 140 and composed of a diffusion plate diffusing light output from the light guide plate 113 and a prism sheet condensing diffused light.

Also, a first polarizer 105a and a second polarizer 106b are respectively disposed at upper and lower sides of the liquid crystal display panel 140.

The light guide plate 113 propagates light input from the side thereof from one side to the other side, and outputs light through an upper surface thereof to supply light to the liquid crystal display panel 140. A pattern 114 is formed on a lower surface of the light guide plate 113, so that light made incident to the pattern 114 is reflected to be supplied to the liquid crystal display panel 140 through the upper surface of the light guide plate 113.

Although not shown in detail, the optical sheet 120 includes the diffusion plate diffusing light output from the light guide plate 113 and the prism sheet condensing light diffused by the diffusion sheet to allow light to be uniformly supplied to the liquid crystal display panel 140. In this case, a sheet in the form of a diffusion sheet may be provided, while the prism sheet may include a first prism sheet and a second prism sheet vertically crossing in x,y-axis directions to refract light in the x,y-axis directions to enhance straightness of light.

The light source 190 is provided on one side of the light guide plate 113, and after light output from the light source is made incident to the light guide plate 113, it is supplied to the liquid crystal display panel 140. In this case, in the drawing, the light source 190 is formed on one side of the light guide plate 113, but the light source 190 may be disposed on both sides of the light guide plate 113 according to a size of a liquid crystal display panel.

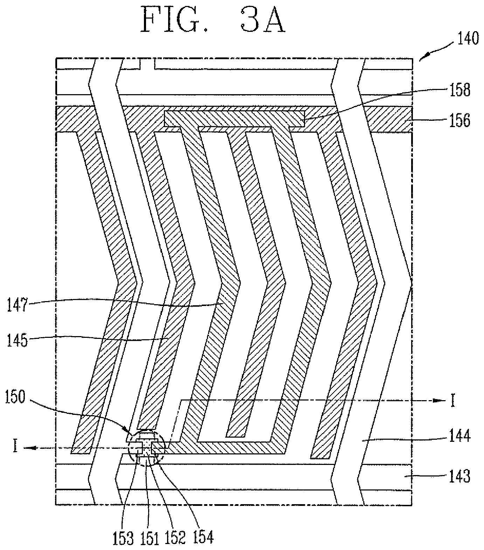

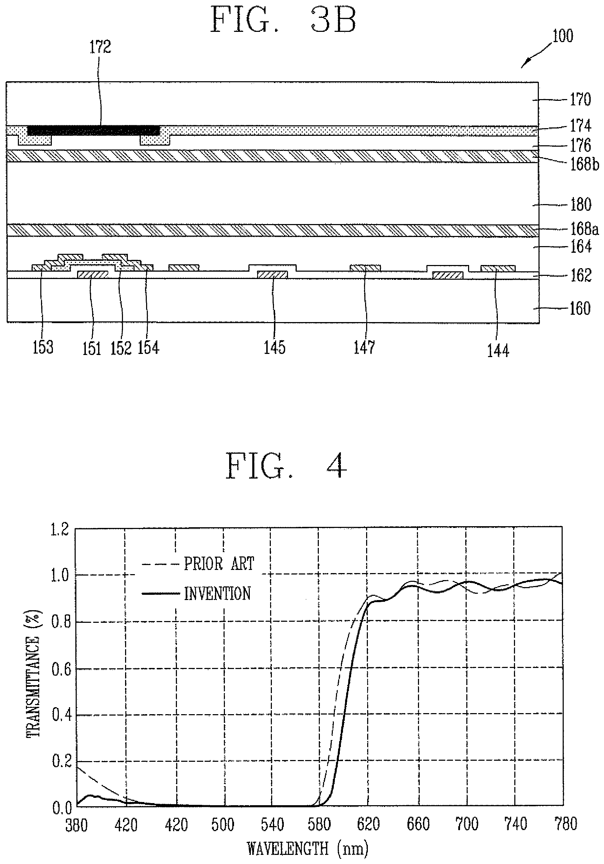

FIG. 3 is a view illustrating a structure of a liquid crystal display panel. FIG. 3A is a plan view and FIG. 3B is a cross-sectional view taken along line I-I' in FIG. 3A. The liquid crystal display panel illustrated in the drawings is an in-plane switching (IPS) mode liquid crystal display panel. Of course, the present disclosure is not limited to the IPS mode liquid crystal display panel. The present disclosure may also be applied to a twisted nematic (TN) mode liquid crystal display panel, a vertical alignment (VA) mode liquid crystal display panel, a fringe field switching (FFS) mode liquid crystal display panel, and the like. Hereinafter, the IPS mode liquid crystal display panel will be described as an example.

As illustrated in FIG. 3A, pixels of the liquid crystal display panel 140 are defined by gate lines 143 and data lines 144 disposed horizontally and vertically, respectively. Although only (n,m)th and (n,m+1)th pixel are displayed in the drawing, but in actuality, in the liquid crystal display panel 140, n number of gate lines 143 and m number of data lines 144 may be disposed to form n x m number of pixels in the entire liquid crystal display panel 140. A transistor 150, e.g. a thin film transistor (TFT) 150, is formed in an intersection of the gate line 143 and the data line 144. The TFT 150 includes a gate electrode 151 to which a scan signal is applied from the gate line 143, a semiconductor layer 152 formed on the gate electrode 151 and forming a channel layer upon being activated by a scan signal applied thereto, and a source electrode 153 and a drain electrode 154 formed on the semiconductor layer 152, to which an image signal is applied through the data line 144, to apply an image signal input from the outside to a liquid crystal layer 180.

In a pixel, a plurality of common electrodes 145 and pixel electrodes 147 are disposed to be arranged to be substantially parallel to the data line 144. Also, a common line 156 connected to the common electrodes 145 is disposed in the middle of the pixel, a pixel electrode line 158 connected to the pixel electrode 157 is disposed on the common line 156 in an overlapping manner. Since the common line 156 and the pixel electrode line 158 overlap, storage capacitance is formed in the IPS mode LCD device.

The common electrode 145 and the pixel electrode 147 are bent one time in a horizontal direction within the pixel. Since the common electrode 145 and the pixel electrode 147 are bent one time, upper and lower regions of the common electrode 145 and the pixel electrode 147 are symmetrical in a horizontal direction based on the center of the pixel.

In the vertical IPS mode LCD device configured as described above, liquid crystal molecules are aligned to be substantially parallel to the common electrode 145 and the pixel electrode 147. When the TFT 150 operates to apply a signal to the pixel electrode 147, an in-plane field is generated to be substantially parallel to the liquid crystal display panel 140 between the common electrode 145 and the pixel electrode 147. Since the liquid crystal molecules are rotated to be parallel to the liquid crystal display panel 140 along the in-plane field, grayscale inversion due to optical anisotropy of the liquid crystal molecules may be prevented.

In this case, since the common electrode 145 and the pixel electrode 147 of the pixel are bent, directions of in-plane fields in the upper region and the lower region based on the central region of the pixel are symmetrical, and thus, liquid crystal molecules are arranged to be symmetrical in the upper region and the lower region. In this manner, since the liquid crystal molecules are arranged to be symmetrical in the single pixel, viewing angle directions are formed to be symmetrical within the single pixel to compensate for each other, and thus, viewing angle characteristics are enhanced.

Meanwhile, in the drawing, the common electrode 145 and the pixel electrode 147 are bent, but the common electrode 145 and the pixel electrode 147 may be formed to have a straight line such that it is perpendicular to the gate line 143, rather than being bent.

The structure of the liquid crystal display panel will be described in more detail with reference to FIG. 3B.

As Illustrated in FIG. 3B, the gate electrode 151 is formed on a first substrate 160, and a gate insulating layer 162 is stacked on the entire first substrate 160. A semiconductor layer 152 is formed on the gate insulating layer 162, and a source electrode 153 and a drain electrode 154 are formed on the semiconductor layer 152. Also, a passivation layer 164 is formed on the entirety of the first substrate 160, and a first alignment layer 168a is formed on the passivation layer 164 to align liquid crystal molecules in a particular direction according to a method such as rubbing, or the like.

Also, a plurality of common electrodes 145 are formed on the first substrate 160, and a pixel electrode 147 and a data line 144 are formed on the gate insulating layer 162 to generate an in-plane field E between the common electrodes 145 and the pixel electrode 147.

In this case, all of the common electrodes 145 and the pixel electrode 147 may be formed on the first substrate 160 or may be formed on the gate insulating layer 162 and the passivation layer 164. Namely, the common electrodes 145 and the pixel electrode 147 may be formed on the same layer or on different layers.

A black matrix 172 and a color filter layer 174 are formed on a second substrate 170. The black matrix 172 serves to prevent leakage of light to a region in which liquid crystal molecules are not operated. As illustrated, the black matrix 172 is mainly formed in the TFT 150 region and a region between pixels (namely, gate line and data line region). The color filter layer 174 includes red (R), blue (B), and green (G) to implement actual colors. An overcoat layer 176 is formed on the color filter layer 174 to protect the color filter layer 174 and enhance smoothness of the substrate, and a second alignment layer 168b having a determined alignment direction is formed on the overcoat layer 176.

A liquid crystal layer 180 is formed between the first substrate 160 and the second substrate 170 to complete the liquid crystal display panel 140.

In the exemplary embodiment of the present disclosure, the liquid crystal display panel 140 is applied to a dashboard of a vehicle, rather than to a TV or a portable electronic device, so a deep red color should be implemented, relative to a general liquid crystal display panel 140.

To this end, in the exemplary embodiment of the present disclosure, deep red is implemented with a material different from that of a related art forming an R-color filter layer.

Namely, in the exemplary embodiment of the present disclosure, an R-color filter layer is formed by using a photosensitive color resin having anthraquinone pigment dispersed therein having a chemical structural formula below.

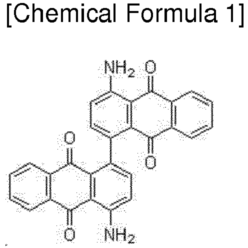

The anthraquinone pigments have a pigment size in the range from about 50µm to about 150µm, preferably in the range from about 70µm to about 90µm. Further, the red color filter layer (174) includes an amount of the anthraquinone pigments in the range from about 40wt% to about 45wt%, preferably in the range from about 41wt% to about 43wt%.

In a case of forming an R-color filter layer by dispersing diketopyrrolo-pyrrole (DDP) pigment having a structure of Chemical Formula 2 according to the related art, yellowish red or orangish red is implemented in implementing red in color coordinates. In contrast, in the case of using anthraquinone pigment of the present disclosure, deep red may be implemented.

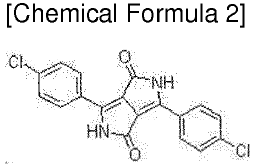

FIG. 4 is a graph illustrating spectrum characteristics of an R-color filter using a color filter having anthraquinone pigment dispersed therein and an R-color filter using a color resin having DDP pigment dispersed therein. As illustrated in FIG. 4, in the case of using the R-color filter according to the exemplary embodiment of the present disclosure, it can be seen that spectrum characteristics were shifted to the right by approximately 10 nm, compared to the case of using the R-color filter having the conventional DDP pigment dispersed therein.

In general, red light has a wavelength ranging from 620 nm to 700 nm. In the case of the related art R-color filter using the R-color filter having the DDP pigment, transmittance is increased from below 620 nm, so it is impossible to implement deep red. In contrast, in the case of the R-color filter according to the exemplary embodiment of the present disclosure in which the anthraquinone pigment was dispersed, since the spectrum characteristics are shifted to the right by approximately 10 nm, transmittance is increased by more than 620 nm, and as a result, deep red light may be implemented, compared to the related art.

Meanwhile, a white light emitting diode (W-LED) is mainly used as the light source 190 in the LCD device. The W-LED 190 supplies white light to the liquid crystal display panel 140.

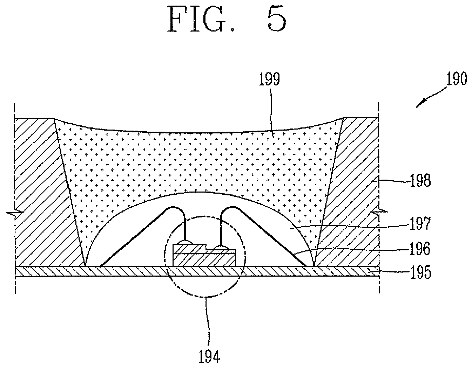

FIG. 5 is a view illustrating a structure of the W-LED according to an exemplary embodiment of the present disclosure.

As illustrated in FIG. 5, the W-LED 190 includes an LED device 194 formed on a substrate 195 and a mold frame 198 accommodating the LED device 194. A protective layer 199 is formed by filling the interior of the mold frame 198 corresponding to an upper side of the LED device 194 with a silicon epoxy, or the like, protecting the LED device 194. In this case, a printed circuit board (PCB) may be used as the substrate 195. Also, although not shown, a static electricity preventing layer may be formed on a surface within or outside of the mold frame 198 to prevent generation of state electricity within the LED device 194.

Although not shown, the LED device 194 may include first semiconductor layers including a N-type semiconductor layer and a P-type semiconductor layer on a semiconductor substrate, and pads formed on the N-type semiconductor layer and the P-type semiconductor layer, respectively, and here, the pads are electrically connected to the substrate 195 by wires 196, to which a signal is applied, and the LED device 194 is surrounded by a fluorescence layer 197.

The fluorescence layer 197 is formed of a fluorescence material having a color different from that of light emitted by the LED device 194, and absorbs a partial amount of light made incident from the LED device 194 to output mixed light (i.e., white light).

The luminance of the light emitting diode is in the range from about 25 Im to about 30 Im, preferably in the range from about 27 Im to about 28.

In the exemplary embodiment of the present disclosure, the LED device 194 emitting blue light is provided, and the fluorescence layer 197 is formed as a layer including a mixture of a green fluorescence material and a red fluorescence material, whereby when blue light is input from the LED device 194 to the fluorescence layer 197, yellow light is emitted from the fluorescence layer 197, and as a result, the yellow light is mixed with blue light emitted from the blue LED device 194 to become white light, and accordingly, white light is output from the LED package 190.

The green fluorescence material and the red fluorescence material forming the fluorescence layer 197 are mixed in a ratio of 2:1. In a general W-LED, the green fluorescence material and the red fluorescence material are mixed by 1:1, but in the exemplary embodiment of the present disclosure, the green fluorescence material and the red fluorescence material are mixed in the ratio of 2:1. The reason is as follows.

In the color filter layer 174 of the liquid crystal display panel 140 according to the exemplary embodiment of the present disclosure, the R-color filter layer is formed of a color resin having anthraquinone pigment dispersed therein.

The R-color filter layer of the anthraquinone pigment is advantageous in that it can implement deep red, but is disadvantageous in that luminance and an aspect ratio are degraded, compared to the R-color filter layer formed of DDP pigment. Thus, when the liquid crystal display panel having the R-color filter layer is applied to a dashboard of a vehicle, quality may be degraded due to a degradation of luminance and aspect ratio.

Thus, in the exemplary embodiment of the present disclosure, the above shortcomings caused by the R-color filter layer are complemented by the W-LED 190 to provide an LCD device capable of implement deep red, while guaranteeing luminance and an aspect ratio equal to those of the general LCD device.

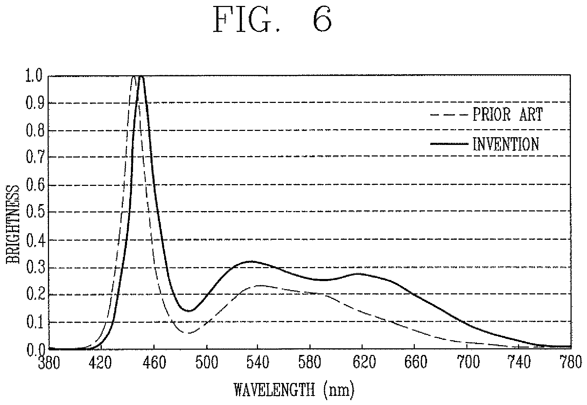

FIG. 6 is a graph illustrating a spectrum denoting luminance of the general W-LED in which the green fluorescence material and the red fluorescence material were mixed by 1:1 and a spectrum denoting luminance of the W-LED in which the green fluorescence material and the red fluorescence material were mixed by 2:1 in accordance with the exemplary embodiments. In FIG. 6, the solid line indicates luminance of the W-LED according to the exemplary embodiment of the present disclosure, and the dotted line indicates luminance of the general W-LED.

As illustrated in FIG. 6, as compared, the related art W-LED and the W-LED according to the exemplary embodiment of the present disclosure have the substantially same luminance in a wavelength range from 440 to 460 nm (namely, a wavelength range of blue light), a short wavelength. In the middle and long wavelength ranges, the related art W-LED does not have a peak, showing a broad spectrum in the wavelength range from 530 to 620 nm without a peak, but in contrast, the LED according the exemplary embodiment of the present disclosure has peaks at wavelength ranges from 520 to 540 nm and from 620 to 630 nm.

In this case, the wavelength ranges of 520 to 540nm and 610 to 630 nm correspond to green light and red light, respectively, so such a spectrum indicates that luminance of green light and that of red light of the W-LED according to the exemplary embodiment of the present disclosure were increased, compared to the related art W-LED. In other words, the W-LED according to the exemplary embodiment of the present disclosure has luminance increased in the red light region, relative to the related art W-LED.

Thus, by compensating for lowered luminance of red light by applying the R-color filter layer of anthraquinone pigment, the LCD device according to the exemplary embodiment of the present disclosure may have luminance substantially equal to that of red light of the general LCD device or rather exert excellent luminance. In addition, in the exemplary embodiment of the present disclosure, since deep red may be implemented by the R-color filter layer of the anthraquinone pigment, deep red may be implemented with luminance equal to that of the general LCD device.

The LCD device for a vehicle configured as described above displays information by implementing green, blue, and red colors according to a type of information. In this case, the B-color filter layer of the color filter layers of the LCD device according to the exemplary embodiment of the present disclosure has pigment identical to that of a color filter layer of the general LCD device, implementing blue having purity and luminance equal to those of the general LCD device, and the G-color filter layer is formed of pigment identical to that of the color filter layer of the general LCD device, but since the W-LED having a high peak value in the wavelength range of green light is used, red having purity equal to that of the general LCD device and enhanced luminance may be implemented.

Also, the R-color filter layer of the LCD device according to the exemplary embodiment of the present disclosure is formed of pigment (anthraquinone pigment) capable of implementing deep red, relative to the color filter layer of the general LCD device, but since the W-LED having a high peak value in the wavelength range of red light is used, red having enhanced purity and luminance relative to those of the general LCD device may be implemented.

Thus, when a red warning display, or the like, is implemented in a dashboard of a vehicle, a color and luminance identical to those of an analog dashboard may be implemented, and thus, drivers may quickly recognize information, warning, or the like, as displayed.

Meanwhile, in the above detailed description, the LCD device having a particular structure is disclosed, but the present disclosure is not limited thereto. The structure disclosed in the detailed description is to describe the present disclosure without limiting coverage of the present disclosure. The present disclosure may be applied to LCD devices having any structure as long as a color resin having anthraquinone pigment dispersed therein is used as a material of an R-color filter layer of a color filter layer and a mixture ratio between a green fluorescence material and a red fluorescence material of a W-LED is 2:1 to implement deep red having enhanced luminance.

For example, the IPS mode, TN mode, VA mode, and FFS mode liquid crystal display panels having liquid crystal display panelliquid crystal display panelan R-color filter layer of a color filter layer made of a color resin dispersed with anthraquinone pigment liquid crystal display panel may be applied as the liquid crystal display device of this invention.

Also, in the detailed description, only the edge type backlight having the W-LED provided on the side of the light guide plate is disclosed, but a direct type backlight in which a W-LED having a green fluorescence material and a red fluorescence material mixed in a ratio of 2:1 is disposed below a light guide plate to allow white light from a lower side of the light guide plate to be made incident to the light guide plate to supply white light to a liquid crystal display panel or a backlight having a structure in which a W-LED is provided below a liquid crystal display panel to directly supply white light to the liquid crystal display panel may also be applied.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A liquid crystal display device (100), comprising:
a plurality of pixels including a liquid crystal layer (180);
a color filter layer (174) disposed over the liquid crystal layer (180), the color filter layer (174) comprising a red color filter layer, a green color filter layer, and a blue color filter layer, wherein the red color filter layer comprises anthraquinone pigments,
wherein the red color filter layer includes a color resin wherein the anthraquinone pigments are dispersed in the color resin, wherein each anthraquinone pigment has the chemical formula: 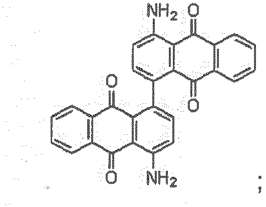
the liquid crystal display device further comprising a backlight (110) configured to provide light to the plurality of pixels,
wherein the backlight (110) comprises a light source (190),
wherein the light source (190) comprises at least one white light emitting diode,
wherein the anthraquinone pigments have a pigment size in the range from about 50µm to about 150µm, and
wherein the red color filter layer (174) comprises an amount of the anthraquinone pigments in the range from about 40wt% to about 45wt%.

2. The liquid crystal display device (100) of claim 1, further comprising:
a plurality of gate lines (143) and a plurality of data lines (144), wherein the plurality of pixels are defined by the plurality of gate lines (143) and the plurality of data lines (144).

3. The liquid crystal display device (100) of claim 1 or 2,
wherein the anthraquinone pigments have a pigment size in the range from about 70µm to about 90µm.

4. The liquid crystal display device (100) of at least one of claims 1 to 3,
wherein the red color filter layer (174) comprises an amount of the anthraquinone pigments in the range from about 41wt% to about 43wt%.

5. A warning light comprising a liquid crystal display device of any one of claims 1 to 4.

6. A dashboard comprising a liquid crystal display device of any one of claims 1 to 4.

## Patentansprüche

1. Eine Flüssigkristall-Anzeigevorrichtung (100), aufweisend:
eine Mehrzahl von Pixeln, die eine Flüssigkristallschicht (180) aufweisen;
eine Farbfilterschicht (174), die über der Flüssigkristallschicht (180) angeordnet ist, wobei die Farbfilterschicht (174) eine rote Farbfilterschicht, eine grüne Farbfilterschicht und eine blaue Farbfilterschicht aufweist, wobei die rote Farbfilterschicht Anthrachinon-Pigmente aufweist,
wobei die rote Farbfilterschicht ein Farbstoff-Harz aufweist, wobei die Anthrachinon-Pigmente in dem Farbstoff-Harz gelöst sind, wobei jedes Anthrachinon-Pigment die chemische Formel 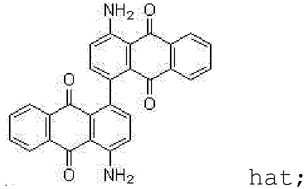
wobei die Flüssigkristall-Anzeigevorrichtung ferner eine Hintergrundbeleuchtung (110), die dazu eingerichtet ist, der Mehrzahl von Pixeln Licht bereitzustellen, aufweist,
wobei die Hintergrundbeleuchtung (110) eine Lichtquelle (190) aufweist,
wobei die Lichtquelle (190) mindestens eine weißes Licht emittierende Diode aufweist,
wobei die Anthrachinon-Pigmente eine Pigmentgröße in dem Bereich von ungefähr 50 µm bis ungefähr 150 µm aufweisen, und
wobei die rote Farbfilterschicht (174) eine Menge der Anthrachinon-Pigmente in dem Bereich von ungefähr 40 Gew.-% bis ungefähr 45 Gew.-% aufweist.

2. Die Flüssigkristall-Anzeigevorrichtung (100) gemäß Anspruch 1, ferner aufweisend:
eine Mehrzahl von Gate-Leitungen (143) und eine Mehrzahl von Datenleitungen (144), wobei die Mehrzahl von Pixeln mittels der Mehrzahl von Gate-Leitungen (143) und der Mehrzahl von Datenleitungen (144) definiert sind.

3. Die Flüssigkristall-Anzeigevorrichtung (100) gemäß Anspruch 1 oder 2,
wobei die Anthrachinon-Pigmente eine Pigmentgröße in dem Bereich von ungefähr 70 µm bis ungefähr 90 µm aufweisen.

4. Die Flüssigkristall-Anzeigevorrichtung (100) gemäß einem der Ansprüche 1 bis 3,
wobei die rote Farbfilterschicht (174) eine Menge der Anthrachinon-Pigmente in dem Bereich von ungefähr 41 Gew.-% bis ungefähr 43 Gew.-% aufweist.

5. Eine Warnlampe, die eine Flüssigkristall-Anzeigevorrichtung gemäß einem der Ansprüche 1 bis 4 aufweist.

6. Ein Armaturenbrett, das eine Flüssigkristall-Anzeigevorrichtung gemäß einem der Ansprüche 1 bis 4 aufweist.

## Revendications

1. Dispositif d'affichage à cristaux liquides (100) comprenant :
une pluralité de pixels comprenant une couche de cristaux liquides (180) ;
une couche de filtre couleur (174) disposée sur la couche de cristaux liquides (180), la couche de filtre couleur (174) comprenant une couche de filtre couleur rouge, une couche de filtre couleur verte, et une couche de filtre couleur bleue, la couche de filtre couleur rouge comprenant des pigments de type anthraquinone,
dans lequel la couche de filtre couleur rouge comprend une résine colorée, les pigments de type anthraquinone étant dispersés dans la résine colorée, chaque pigment de type anthraquinone répondant à la formule chimique : 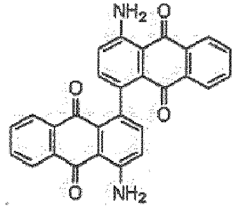
le dispositif d'affichage à cristaux liquides comprenant en outre un rétroéclairage (110) configuré pour fournir de la lumière à la pluralité de pixels,
dans lequel le rétroéclairage (110) comprend une source de lumière (190),
dans lequel la source de lumière (190) comprend au moins une diode émettant une lumière blanche,
dans lequel les pigments de type anthraquinone ont une taille de pigment comprise entre environ 50 µm et environ 150 µm, et
dans lequel la couche de filtre couleur rouge (174) comprend une quantité des pigments de type anthraquinone comprise entre environ 40 % en poids et environ 45 % en poids.

2. Dispositif d'affichage à cristaux liquides (100) selon la revendication 1, comprenant en outre une pluralité de lignes de grille (143) et une pluralité de lignes de données (144), dans lequel la pluralité de pixels est définie par la pluralité de lignes de grille (143) et la pluralité de lignes de données (144).

3. Dispositif d'affichage à cristaux liquides (100) selon la revendication 1 ou 2, dans lequel les pigments de type anthraquinone ont une taille de pigment comprise entre environ 70 µm et environ 90 µm.

4. Dispositif d'affichage à cristaux liquides (100) selon au moins l'une des revendications 1 à 3, dans lequel la couche de filtre couleur rouge (174) comprend une quantité des pigments de type anthraquinone comprise entre environ 41 % en poids et environ 43 % en poids.

5. Voyant de signalisation comprenant un dispositif d'affichage à cristaux liquides selon l'une quelconque des revendications 1 à 4.

6. Tableau de bord comprenant un dispositif d'affichage à cristaux liquides selon l'une quelconque des revendications 1 à 4.
